# EUROPEAN PATENT APPLICATION

(11) **EP 4 553 898 A2**
(43) Date of publication of application: **14.05.2025**
(21) Application number: 24193106.2
(22) Date of filing: 06.08.2024
(51) Int. Cl.: H01L 25/065

(54) **THREE-DIMENSIONAL INTEGRATED CIRCUIT INCLUDING SWITCH CELL**

(30) Priority: 13.11.2023 KR 20230156752; 07.02.2024 KR 20240018836
(71) Applicant: SAMSUNG ELECTRONICS CO., LTD., Yeongtong-gu Suwon-si, Gyeonggi-do 16677 (KR)
(72) Inventor: HONG, Yongjin, 16677 Suwon-si, Gyeonggi-do (KR); KIM, Ki-Ok, 16677 Suwon-si, Gyeonggi-do (KR)
(74) Representative: Kuhnen & Wacker Patent- und Rechtsanwaltsbüro PartG mbB

(57) **Abstract**

A three-dimensional integrated circuit (300) may include a switch cell (311) located on a first substrate within a first die (310) among a plurality of stacked dies (310, 320), and configured to output a virtual power voltage (VVDD) based on a power voltage (RVDD) received from the outside, a first interface module (315) located on the first substrate, and configured to enter an active mode based on the virtual power voltage (VVDD), and a second interface module (321) located on a second substrate within a second die (320) bonded to the first die (310) among a plurality of dies (310, 320), and configured to enter the active mode together with the first interface module (315) based on the virtual power voltage (VVDD).

## Description

### BACKGROUND OF THE INVENTION

As electronic devices, such as electronic portable devices, become smaller, semiconductor devices mounted on electronic devices are also gradually becoming smaller and lighter. As semiconductor devices become smaller, three-dimensional integrated circuits in which multiple chips are stacked are being manufactured to integrate more circuits in a limited space.

Meanwhile, along with miniaturization and weight reduction of semiconductor devices, the demand for power saving is increasing. As one of these power saving methods, power gating technology is used. Power gating refers to a technology in which, by using a switch cell, a power voltage is supplied to a logic circuit in the active mode of the logic circuit and the power voltage supplied to the logic circuit is blocked in the sleep mode of the logic circuit, by which the leakage current in logic circuits may be reduced.

### SUMMARY OF THE INVENTION

In general, in some implementations, the present disclosure is directed to a three-dimensional integrated circuit including a switch cell capable of efficiently utilizing the area of a plurality of integrated circuits, and a three-dimensional integrated circuit including a switch cell capable of decreasing power consumption.

An integrated circuit may include a first switch cell on a first substrate within a first die among a plurality of stacked dies, the first switch cell being configured to output a virtual power voltage based on a power voltage received from an exterior of the first die, a first interface circuit on the first substrate, the first interface circuit configured to enter an active mode based on the virtual power voltage, and a second interface circuit on a second substrate within a second die bonded to the first die among a plurality of dies, the second interface circuit configured to enter the active mode together with the first interface circuit based on the virtual power voltage.

An integrated circuit may include a first die among a plurality of dies, the first die including a first plurality of metal lines extending in a first direction, a plurality of switch cells disposed to overlap the first plurality of metal lines and configured to provide a virtual power voltage to the first plurality of metal lines based on a power voltage received from an exterior of the first die, and a first interface circuit configured to enter an active mode based on the virtual power voltage, and a second die among a plurality of dies including a second plurality of metal lines extending in the first direction and configured to receive the virtual power voltage from the first die and a second interface circuit disposed to overlap the second plurality of metal lines and to enter the active mode together with the first interface circuit based on the virtual power voltage received from the second plurality of metal lines.

A semiconductor device may include a first die including a switch cell configured to output a virtual power voltage of a first level based on a power voltage received from an exterior of the first die, a first interface circuit configured to output a logic signal based on the virtual power voltage of the first level received from the switch cell, a level shifter configured to output the virtual power voltage of a second level different from the first level based on the virtual power voltage of the first level received from the switch cell, a first through-silicon via configured to transfer the virtual power voltage of the second level to the exterior of the first die, and a second through-silicon via configured to transfer the logic signal to the exterior of the first die, and a second die including a second interface circuit receiving the logic signal through the second through-silicon via based on the virtual power voltage of the second level received from the first through-silicon via.

### BRIEF DESCRIPTION OF THE DRAWINGS

Example implementations will be more clearly understood from the following detailed description, taken in conjunction with the accompanying drawings.
FIG. 1 is a drawing showing an example of a three-dimensional integrated circuit having a through-silicon via (TSV) according to some implementations.
FIG. 2 is a drawing showing an example of a switch cell according to some implementations.
FIG. 3 is a drawing showing an example of an operation method of a three-dimensional integrated circuit according to some implementations.
FIG. 4 is a drawing showing an example of a layout of the first semiconductor die of FIG. 3 according to some implementations.
FIG. 5 is a drawing three-dimensionally showing an example of a metal line connected to a switch cell according to some implementations.
FIG. 6 is a drawing schematically showing an example of a layout of the second semiconductor die of FIG. 3 according to some implementations.
FIG. 7 is a drawing three-dimensionally showing an example of a connection between a first semiconductor die and a second semiconductor die according to some implementations.
FIG. 8 is a schematic cross-sectional view of an example of a three-dimensional integrated circuit according to some implementations.
FIG. 9 is a schematic cross-sectional view of an example of a three-dimensional integrated circuit according to some implementations.
FIG. 10 is a schematic cross-sectional view of an example of a three-dimensional integrated circuit according to some implementations.
FIG. 11 is a schematic cross-sectional view of an example of a three-dimensional integrated circuit according to some implementations.
FIG. 12 is a drawing for schematically explaining an example of an operation method of a three-dimensional integrated circuit according to some implementations.
FIG. 13 is a drawing for schematically showing an example of an operation method of a three-dimensional integrated circuit according to some implementations.
FIG. 14 is a drawing showing an example of a three-dimensional integrated circuit according to some implementations.
FIG. 15 is a drawing showing an example of a semiconductor device according to some implementations.

### DETAILED DESCRIPTION

Hereinafter, example implementations will be described with reference to the accompanying drawings.

In the present disclosure, the dimensions of components are not limited to a disclosed range or value but may vary depending on process conditions and/or desired device properties. In addition, formation of a first structure on or above a second structure may include implementations in which the first and second structures are formed by direct contact, and may also include implementations in which an additional structure is formed between the first and second structures, such that the first and second structures do not contact directly. For simplicity and clarity, various structures may be arbitrarily drawn at different scales.

In addition, terms with a spatial relationship, such as "below," "lower," "under," "above," and "top," may be used for convenience in description of a relationship for other elements or structures of an element or structure illustrated in the drawing. Like reference numerals designate like elements throughout the specification.

In addition, expressions described in the singular may be interpreted in the singular or plural unless explicit expressions such as "one" or "single" are used. Terms including ordinal numbers, such as first and second, may be used to describe various components, but the components are not limited by these terms. These terms may be used for the purpose of distinguishing one component from another.

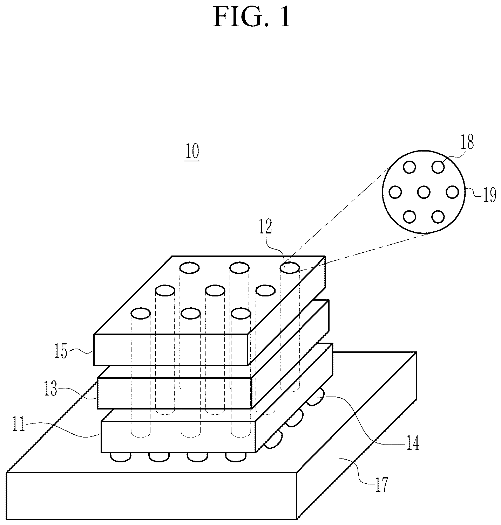

FIG. 1 is a drawing showing an example of a three-dimensional integrated circuit having a through-silicon via (TSV) according to some implementations. In FIG. 1, a three-dimensional integrated circuit 10 may include semiconductor dies 11, 13, and 15 and a printed circuit board (PCB) 17. Each of the semiconductor dies 11, 13, and 15 of the three-dimensional integrated circuit 10 may be connected by a through-silicon vias 12. Each of the semiconductor dies 11, 13, and 15 may transmit and receive a logic signal or power voltage through the through-silicon vias 12.

In some implementations, at least one through-silicon via 12 may configure a unit through via structure 19. The unit through via structure 19 may include a plurality of through-silicon vias 18 that are regularly arranged. For example, each of the semiconductor dies 11, 13, and 15 may transmit and receive the logic signal or power voltage through the unit through via structure 19.

Additionally, in some implementations, a micro-bump, solder bump, hybrid copper bonding (HCB), or the like may be located between the semiconductor dies 11, 13, and 15. The semiconductor dies 11, 13, and 15 may be electrically connected through the micro-bump, solder bump, hybrid copper bonding, or the like located between the semiconductor dies 11, 13, and 15.

In some implementations, at least one of the semiconductor dies 11, 13, and 15 may include a switch cell. The switch cell may receive a power voltage RVDD, and may output a virtual power voltage VVDD applied to a logic circuit performing a preset logical operation. In some implementations, only some (at least one) of the semiconductor dies 11, 13, and 15 die may include the switch cell. The switch cell included only in at least one die of the semiconductor dies 11, 13, and 15 may output the virtual power voltage, and may transfer the virtual power voltage to remaining semiconductor dies through the at least one through-silicon via 12. The interface module included in each of the semiconductor dies 11, 13, and 15 may transmit and receive the logic signal between the semiconductor dies 11, 13, and 15 based on the virtual power voltage.

The semiconductor dies 11, 13, and 15 and the printed circuit board 17 may be electrically connected through a micro-bump, a solder bump, a solder ball 14, or the like.

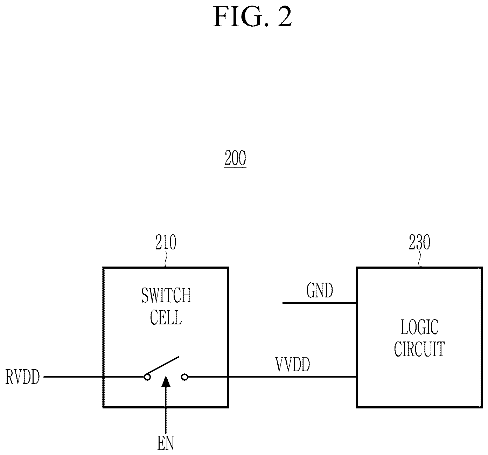

FIG. 2 is a drawing showing an example of a switch cell according to some implementations. In FIG. 2, an integrated circuit 200 may include a logic circuit 230 and a switch cell 210 configured to provide a power voltage to the logic circuit 230. Here, the integrated circuit 200 may refer to one of the semiconductor dies 11, 13, and 15 of FIG. 1. The integrated circuit 200 may be a system-on-chip (SOC), but is not limited thereto.

In some implementations, the switch cell 210 may receive the power voltage RVDD from the outside. The switch cell 210 may denote an element configured to selectively block the flow of current through the switch cell 210 based on a control signal EN. The power voltage selectively output by the switch cell 210 may be referred to as the virtual power voltage VVDD. Depending on the virtual power voltage VVDD selectively output by the switch cell 210, the logic circuit 230 may operate in different modes. For example, in an active mode of the logic circuit 230, the switch cell 210 may supply the virtual power voltage VVDD to the logic circuit 230, and in a sleep mode of the logic circuit 230, the switch cell 210 may block the supply of the virtual power voltage VVDD to the logic circuit 230. Since the switch cell 210 selectively outputs the virtual power voltage VVDD according to an operation mode of the logic circuit 230, the leakage current of the logic circuit 230 may be reduced.

In some implementations, the logic circuit 230 may receive the virtual power voltage VVDD from the switch cell 210, and further receive a ground voltage GND from the outside. The logic circuit 230 may receive or output a logic signal based on the virtual power voltage VVDD. The logic circuit 230 may include various cells for implementing a logic circuit. For example, the logic circuit 230 may include various logic devices such as an AND gate, an OR gate, a NOR gate, an XOR gate, an inverter, or the like or various memory elements, such as latch, flip-flop, or the like, or may be one of them.

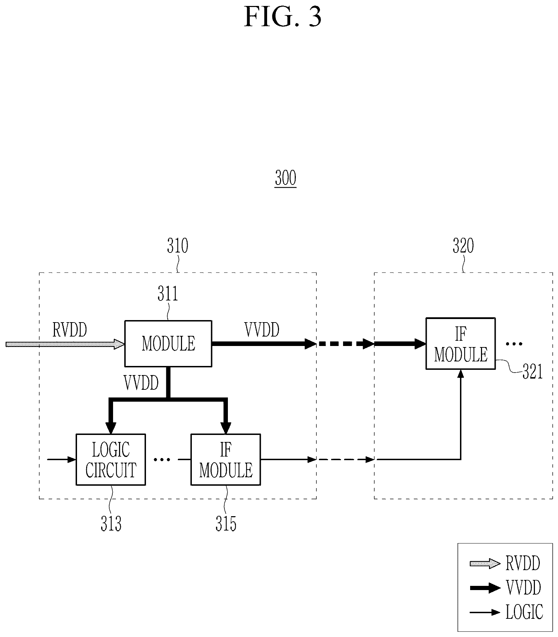

FIG. 3 is a drawing showing an example of an operation method of a three-dimensional integrated circuit according to some implementations. In FIG. 3, a three-dimensional integrated circuit 300 may include a first semiconductor die 310 and a second semiconductor die 320. The first semiconductor die 310 may include a switch cell 311. The switch cell 311 may receive the power voltage RVDD from an exterior of the first semiconductor die 310, and may output the virtual power voltage VVDD. The second semiconductor die 320 may not include a switch cell.

In some implementations, the switch cell 311 may provide the virtual power voltage VVDD to a logic circuit 313 and a first interface module (circuit) 315, and may also provide the virtual power voltage VVDD to a second interface module (circuit) 321 within the second semiconductor die 320. The switch cell 311 may provide the virtual power voltage VVDD to the second interface module 321 through a substrate-through via, a micro-bump, a solder bump, a hybrid copper bonding (HCB), or the like electrically connecting the first and second semiconductor dies 310 and 320. The logic circuit 313, the first interface module 315, and the second interface module 321 may operate in the active mode based on the virtual power voltage VVDD. The logic circuit 313, the first interface module 315, and the second interface module 321 may simultaneously operate in the active mode based on the virtual power voltage VVDD. The logic circuit 313, the first interface module 315, and the second interface module 321 may receive or output a logic signal in the active mode.

In some implementations, the first and second interface modules 315 and 321 included in each of the first and second semiconductor dies 310 and 320 may be a circuit configured to transmit and receive the logic signal between the first and second semiconductor dies 310 and 320. The first and second interface modules 315 and 321 may include various logic devices. For example, the first and second interface modules 315 and 321 may be various logic devices, such as an AND gate, an OR gate, a NOR gate, an XOR gate, an inverter, or the like, or a memory element, such as a latch, flip-flop, or the like. The first and second interface modules 315 and 321 may receive the virtual power voltage VVDD from the switch cell 311, and may enter the active mode. The first and second interface modules 315 and 321 may transmit and receive the logic signal in the active mode, in which the through a substrate-through via, a micro-bump, a solder bump, a hybrid copper bonding (HCB), or the like are electrically interconnecting the first and second semiconductor dies 310 and 320.

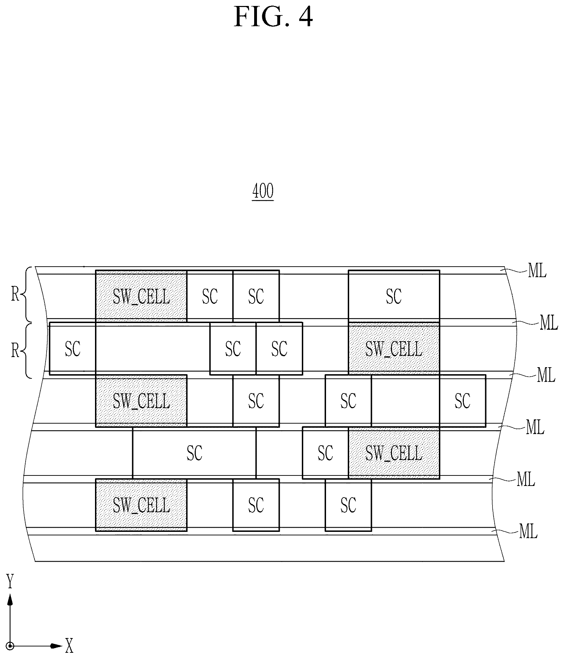

FIG. 4 is a drawing schematically showing an example of a layout of the first semiconductor die of FIG. 3 according to some implementations. Specifically, a semiconductor die that includes the switch cell.

In FIG. 4, a first semiconductor die 400 may include switch cells SW_CELL. The first semiconductor die 400 may further include standard cells SC disposed between the switch cells SW_CELL. Here, the standard cells SC may include a logic device, a memory element, a filler cell, and the like.

In some implementations, the switch cell SW_CELL may be disposed in a different row from switch cells SW_CELL adjacent in a row R direction. For example, a row direction may denote X direction. An interval between adjacent switch cells SW_CELL in the row direction may be preset. An interval between adjacent switch cells SW_CELL in the row direction may be a distance preset to stably provide the virtual power voltage VVDD to the standard cells SC. The switch cell SW_CELL may be disposed to cross in a column direction. For example, the column direction may denote Y direction. However, the arrangement of the switch cell SW_CELL is not limited to the structure of FIG. 4, and may be disposed in various ways in an appropriate structure to provide the virtual power voltage VVDD to the standard cells SC.

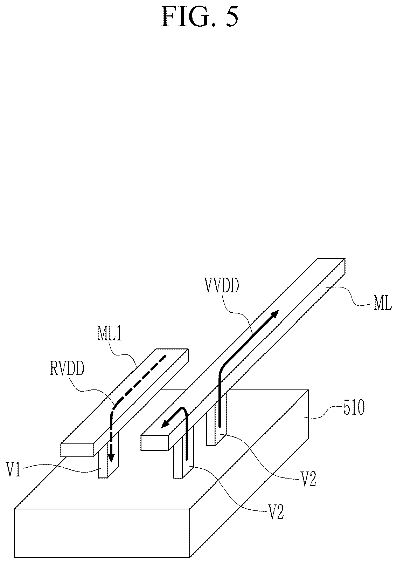

In some implementations, the first semiconductor die 400 may include a plurality of metal lines ML that extend in the row direction (e.g., X-direction). The plurality of metal lines ML may cross each other to provide the virtual power voltage VVDD and the ground voltage GND. In some implementations, the switch cells SW_CELL may be disposed to overlap the metal lines ML. The standard cells SC may also be disposed to overlap the metal lines ML. Here, the switch cells SW_CELL and the standard cells SC are shown to be disposed in each row R, but it is not limited thereto, and the switch cells SW_CELL and the standard cells SC may be formed to span a plurality of rows R. The switch cells SW_CELL may provide the virtual power voltage VVDD to the standard cells SC through the metal lines ML. Detailed description on this will be described later with reference to FIG. 5.

FIG. 5 is a drawing three-dimensionally showing an example of a metal line connected to a switch cell according to some implementations. In FIG. 5, a first via V1 and a second via V2 may be formed on a switch cell 510. The first via V1 may be electrically connected to a first metal line ML1. The second via V2 may be electrically connected to a second metal line ML. The directions along which the first metal line ML1 and the second metal line ML extend may be identical to or different from each other. Meanwhile, the structure of FIG. 5 is merely for better understanding and ease of description, and the number, locations, an elongation direction of metal lines, and the like of vias are not limited to the structure shown in FIG. 5.

In some implementations, the switch cell 510 may receive the power voltage RVDD from the outside through the first metal line ML1 and the first via V1. The switch cell 510 may provide the virtual power voltage VVDD to surroundings through the second via V2 and the second metal line ML. Here, the second metal line ML may represent the metal line ML of FIG. 4.

In some implementations, the switch cell 510 may provide the virtual power voltage VVDD to the standard cells SC through the second metal line ML. The standard cells SC may be disposed to overlap the second metal line ML, and accordingly, may be provided with the virtual power voltage VVDD from the switch cell 510 through the second metal line ML. The standard cells SC may enter the active mode based on the virtual power voltage VVDD received through the metal lines ML. The standard cells SC may be provided with the virtual power voltage VVDD through vias or the like connected to the second metal line ML and the standard cells SC.

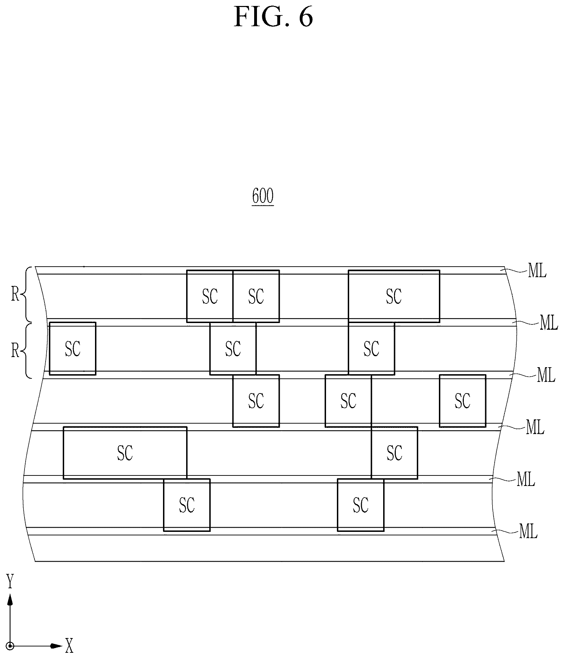

FIG. 6 is a drawing schematically showing an example of a layout of the second semiconductor die of FIG. 3 according to some implementations. Specifically, a semiconductor die that does not include the switch cell.

In FIG. 6, similar to the first semiconductor die 400 of FIG. 4, a second semiconductor die 600 may include the plurality of metal lines ML extending in the row direction (e.g., X-direction). The second semiconductor die 600 may include a plurality of standard cells SC. Here, standard cells may include a logic device, a memory element, a filler cell, and the like. In some implementations, the standard cells SC may be disposed to overlap the metal lines ML. In addition, the standard cells SC may be formed to span the plurality of rows R.

The plurality of metal lines ML may cross each other to provide the virtual power voltage VVDD and the ground voltage GND. The standard cells SC may receive the virtual power voltage VVDD and the ground voltage GND through the metal lines ML. The standard cells SC may enter the active mode based on the virtual power voltage VVDD received through the metal lines ML. Since the second semiconductor die 600 does not include the switch cell, the metal lines ML may receive the virtual power voltage VVDD from the outside. The metal lines ML of the second semiconductor die 600 may receive the virtual power voltage VVDD from the outside through a substrate-through via, a bump, a hybrid copper bonding, or the like.

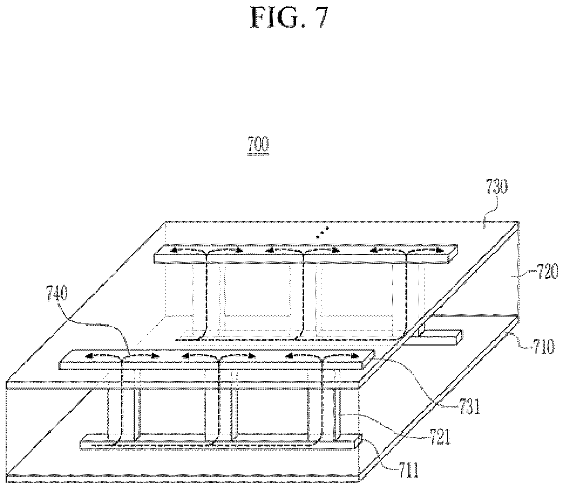

FIG. 7 is a drawing three-dimensionally showing an example of a connection between a first semiconductor die and a second semiconductor die according to some implementations. Specifically, the virtual power voltage is provided from the first semiconductor die to the second semiconductor die. Here, an example in which the virtual power voltage is provided through a substrate-through via will be described. However, in a similar structure and method, the virtual power voltage may be provided from the first semiconductor die to the second semiconductor die through a bump, a hybrid copper bonding, or the like.

In FIG. 7, in a three-dimensional integrated circuit 700, a second semiconductor die 730 may receive a virtual power voltage (VVDD) 740 from a first semiconductor die 710. The first semiconductor die 710 may provide the virtual power voltage 740 to the second semiconductor die 730 through a through-silicon via 721 penetrating a substrate 720.

In some implementations, the first semiconductor die 710 may include the switch cell. The switch cell of the first semiconductor die 710 may be disposed to overlap metal lines 711 on the first semiconductor die 710. The switch cell of the first semiconductor die 710 may provide the virtual power voltage 740 to standard cells on the first semiconductor die 710 through the metal line 711. The structure in which the switch cell and standard cells are disposed in the first semiconductor die 710 may be the same as or similar to the structure explained with reference to FIGS. 4 and 5.

In some implementations, the second semiconductor die 730 may include the plurality of standard cells. The first semiconductor die 710 may provide the virtual power voltage 740 to the plurality of standard cells on the second semiconductor die 730 through the through-silicon via 721. The through-silicon via 721 may be electrically connected to the metal lines 711 on the first semiconductor die 710 and metal lines 731 on the second semiconductor die 730. The first semiconductor die 710 may provide the virtual power voltage 740 to the metal lines 731 on the second semiconductor die 730 through the through-silicon via 721. The plurality of standard cells on the second semiconductor die 730 may be disposed to overlap the metal lines 731 on the second semiconductor die 730. The plurality of standard cells on the second semiconductor die 730 may be provided with the virtual power voltage 740 through vias or metal lines connected to the second semiconductor die 730. The structure in which standard cells are disposed in the second semiconductor die 730 may be the same as or similar to the structure explained with reference to FIG. 6.

Meanwhile, the region provided with the virtual power voltage 740 from the first semiconductor die 710 may be an entire region of the second semiconductor die 730, or may be a partial region thereof.

In addition, although the three-dimensional integrated circuit 700 includes two semiconductor dies, it is not limited thereto, and the three-dimensional integrated circuit 700 may further include at least one semiconductor die, above and/or below the first semiconductor die 710 and the second semiconductor die 730.

A three-dimensional integrated circuit may implement the power gating by using the switch cell, thereby reducing power consumption. In addition, since it is designed such that only some (at least one) semiconductor die among a plurality of semiconductor dies of the three-dimensional integrated circuit includes the switch cell, the area of the integrated circuit may be efficiently utilized.

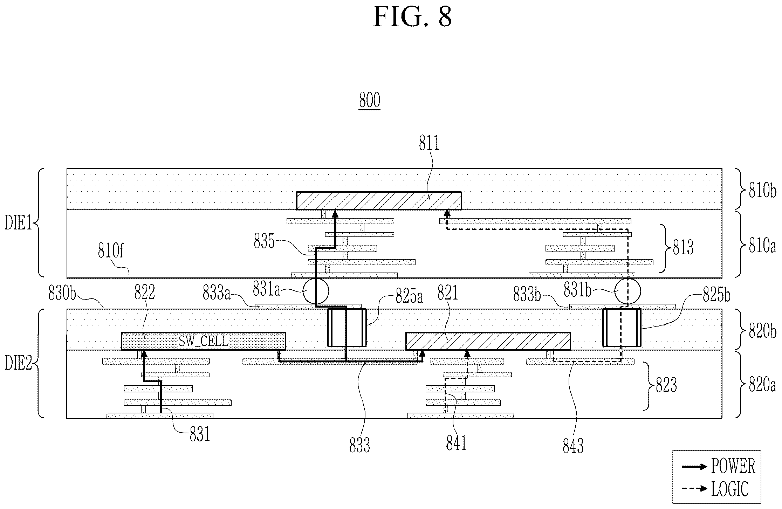

FIG. 8 is a schematic cross-sectional view of an example of a three-dimensional integrated circuit according to some implementations. Specifically, in the three-dimensional integrated circuit 800 a front surface 810f of a first semiconductor die DIE1 and a rear surface 830b of a second semiconductor die DIE2 are disposed in contact with each other, wherein the second semiconductor die DIE2 includes the switch cell SW_CELL. The first semiconductor die DIE1 may be a top die, and the second semiconductor die DIE2 may be a bottom die. Here, although only a portion of the three-dimensional integrated circuit 800 is illustrated, each die may include more configurations. In addition, the three-dimensional integrated circuit 800 may include additional dies above and/or below the first semiconductor die DIE1 and the second semiconductor die DIE2.

In some implementations, the first semiconductor die DIE1 may include a first BEOL layer 810a and a first substrate layer 810b. For example, the first substrate layer 810b may be a semiconductor substrate material such as silicon or may include the same. A first semiconductor device 811 may be disposed above the first substrate layer 810b and/or within the first substrate layer 810b. For example, the first semiconductor device 811 may be or may include an active element(s), such as a metal-oxide-semiconductor field-effect transistor (MOSFET) or the like. Hereinafter, the first semiconductor device 811 included in the first substrate layer may be referred to as a first interface module (circuit) configured to transmit and receive the logic signal between different dies.

In some implementations, the first semiconductor die DIE1 may include the first BEOL layer 810a disposed adjacent to the first substrate layer 810b. The first BEOL layer 810a may include a first plurality of metal layers 813. The first plurality of metal layers may include the plurality of metal lines and a plurality of metal vias connecting the same. In some implementations, the first plurality of metal layers 813 may include the metal line ML according to FIGS. 6 and 7. A first interface module 811 may receive power voltage through the first plurality of metal layers 813, or transmit and receive the logic signal.

In some implementations, the second semiconductor die DIE2 may include a second BEOL layer 820a and a second substrate layer 820b. For example, the second substrate layer 820b may be a semiconductor substrate material, such as silicon or may include the same. A second semiconductor device 821 and a switch cell 822 may be disposed above the second substrate layer 820b and/or within the second substrate layer 820b. Hereinafter, the second semiconductor device 821 included in the second substrate layer 820b may be referred to as a second interface module (circuit) configured to transmit and receive the logic signal between different dies.

In some implementations, the second semiconductor die DIE2 may include the second BEOL layer 820a disposed adjacent to the second substrate layer 820b. The second BEOL layer 820a may include a second plurality of metal layers 823. The second plurality of metal layers 823 may include a plurality of metal lines and vias. In some implementations, the second plurality of metal layers 823 may include the metal line ML according to FIG. 4 and FIG. 5. The switch cell 822 may receive power voltage through the second plurality of metal layers 823, and output the virtual power voltage VVDD. A second interface module 821 may receive the virtual power voltage VVDD through the second plurality of metal layers 823, and may output or receive the logic signal.

In some implementations, the second substrate layer 820b may include through-silicon vias 825a and 825b that extend to penetrate the second substrate layer 820b. The through-silicon vias 825a and 825b may extend from a surface on which the second substrate layer 820b and the second BEOL layer 820a are in contact to an opposite surface (e.g., the rear surface 830b of the second substrate). The through-silicon vias 825a and 825b may provide an electrical connection between the second plurality of metal layers 823 and redistribution layers (RDL) 833a and 833b through conductive materials within the through-silicon vias 825a and 825b.

In some implementations, the redistribution layers 833a and 833b for forming electrical connection to adjacent dies may be located on the rear surface 830b of the second substrate layer 820b. The redistribution layers 833a and 833b may include a plurality of metallization patterns between adjacent dies. The redistribution layers 833a and 833b may form an electrical connection to the second plurality of metal layers 823 through conductive materials within the through-silicon vias 825a and 825b.

In some implementations, an upper metal line of the first plurality of metal layers 813 may be connected to interconnection structures 831a and 831b. Here, the interconnection structures 831a and 831b may include a bump (e.g., micro-bump or solder bump), a hybrid copper bonding, or the like. The interconnection structures 831a and 831b may be formed of a conductive material, such as copper, aluminum, or the like. The first plurality of metal layers 813 may transmit and receive power voltage and the logic signals to and from the outside through the interconnection structures 831a and 831b. The first semiconductor die DIE1 and the second semiconductor die DIE2 may transmit and receive the power voltage and the logic signals through the interconnection structures 831a and 831b, redistribution layers 833a and 833b, the through-silicon vias 825a and 825b, and the like. However, in some implementations, some of these configurations may be omitted or other necessary configurations may be added as needed.

In some implementations, the switch cell 822 may receive the power voltage RVDD from the outside through a first path 831. The switch cell 822 may output the virtual power voltage VVDD based on the control signal. The switch cell 822 may provide the virtual power voltage VVDD to the second interface module 821 through a second path 833, and may provide the virtual power voltage VVDD to the first interface module 811 through a third path 835. The switch cell 822 may provide the virtual power voltage VVDD to the second interface module 821 through the second plurality of metal layers 823. For example, the switch cell 822 may provide the virtual power voltage VVDD to the second interface module 821 through a metal layer among the second plurality of metal layers 823 within a routing path to the second interface module 821. The switch cell 822 may provide the virtual power voltage VVDD to the first interface module 811 through the through-silicon via 825a, the redistribution layer 833a, the interconnection structure 831a, and the like. For example, the switch cell 822 may provide the virtual power voltage VVDD to the first interface module 811 through a metal layer among the second plurality of metal layers 823 within a routing path from the switch cell 822 to the through-silicon via 825a, the through-silicon via 825a, the redistribution layer 833a, the interconnection structure 831a, and a metal layer among the first plurality of metal layers 813 within a routing path from the interconnection structure 831a to the first interface module 811.

In some implementations, the first interface module 811 and the second interface module 821 may operate in the active mode based on the virtual power voltage VVDD. The first interface module 811 and the second interface module 821 may operate together in the active mode based on the virtual power voltage VVDD. When the second interface module 821 enters the active mode, it may receive a first input logic signal from external or other logic devices through a fourth path 841. The second interface module 821 may output a first output logic signal as a response to the first input logic signal. The second interface module 821 may output the first output logic signal through a fifth path 843. For example, the first output logic signal may be provided to the first interface module 811 as a second input logic signal through a through-silicon via 825b, a redistribution layer 833b, an interconnection structure 831b, or the like. The first output logic signal may be provided to the first interface module 811 as the second input logic signal through a metal layer among the second plurality of metal layers 823 within a routing path from the second interface module 821 to the through-silicon via 825b, the through-silicon via 825b, the redistribution layer 833b, the interconnection structure 831b, and a metal layer among the first plurality of metal layers 813 within the routing path from the interconnection structure 831a to the first interface module 811.

However, although the first interface module 811 receives the logic signal output by the second interface module 821 is described, the scope of the present disclosure is not limited thereto. For example, the second interface module 821 may receive the logic signal output by the first interface module 811 based on the virtual power voltage VVDD. At this time, the path along which the logic signal moves may be similar to the path of the logic signal described above.

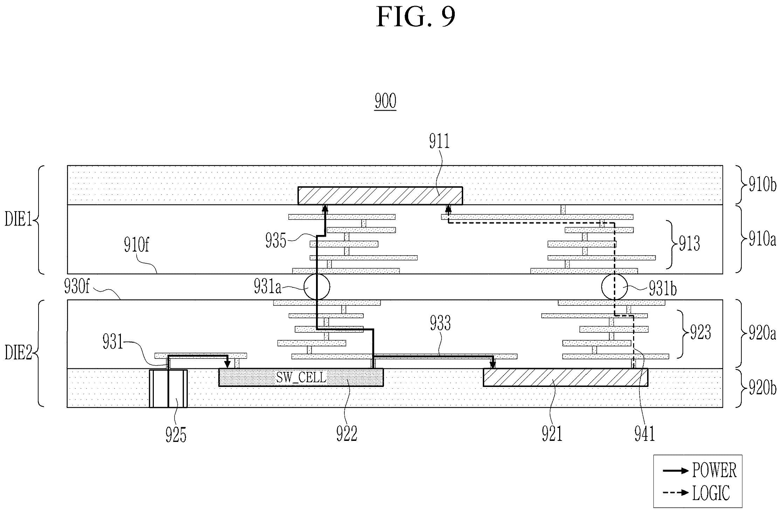

FIG. 9 is a schematic cross-sectional view of an example of a three-dimensional integrated circuit according to some implementations. Specifically, ,in a three-dimensional integrated circuit 900 a front surface 910f of the first semiconductor die DIE1 and a front surface 930f of the second semiconductor die DIE2 are disposed in contact with each other, wherein the second semiconductor die DIE2 includes the switch cell SW_CELL. The first semiconductor die DIE1 may be a top die, and the second semiconductor die DIE2 may be a bottom die. Here, although only a portion of the three-dimensional integrated circuit 900 is illustrated, each die may include more configurations. In addition, the three-dimensional integrated circuit 900 may include additional dies above and/or below the first semiconductor die DIE1 and the second semiconductor die DIE2. In addition, descriptions redundant to FIG. 8 is not included herein.

The first plurality of metal layers 913 of the first semiconductor die DIE1 and a second plurality of metal layers 923 of the second semiconductor die DIE2 may be connected to interconnection structures 931a and 931b. The first semiconductor die DIE1 and the second semiconductor die DIE2 may transmit and receive power voltage and the logic signals through the interconnection structures 931a and 931b.

In some implementations, a first substrate layer 910b of the first semiconductor die DIE1 may include a first interface module (circuit) 911. A second substrate layer 920b of the second semiconductor die DIE2 may include a switch cell 922 and a second interface module (circuit) 921.

In some implementations, the switch cell 922 may receive the power voltage RVDD from the outside through a through-silicon via 925. The switch cell 922 may receive the power voltage RVDD from the outside through a first path 931.

In some implementations, the switch cell 922 may output the virtual power voltage VVDD based on the control signal. The switch cell 922 may provide the virtual power voltage VVDD to the second interface module 921 through a second path 933, and may provide the virtual power voltage VVDD to the first interface module 911 through a third path 935. The switch cell 922 may provide the virtual power voltage VVDD to the second interface module 921 through the second plurality of metal layers 923. The switch cell 922 may provide the virtual power voltage VVDD to the second interface module 921 through a metal layer among the second plurality of metal layers 923 within a routing path from the switch cell 922 to the second interface module 921. The switch cell 922 may provide the virtual power voltage VVDD to the first interface module 911 through the second plurality of metal layers 923, the interconnection structure 931a, the first plurality of metal layers 913, and the like. For example, the switch cell 922 may provide the virtual power voltage VVDD to the first interface module 911 through a metal layer among the second plurality of metal layers 923 within a routing path from the switch cell 922 to the interconnection structure 931a, the interconnection structure 931a, and a metal layer among the first plurality of metal layers 913 within a routing path from the interconnection structure 931a to the first interface module 911.

In some implementations, the first interface module 911 and the second interface module 921 may operate in the active mode based on the virtual power voltage VVDD. The first interface module 911 and the second interface module 921 may operate together in the active mode based on the virtual power voltage VVDD. When the second interface module 921 enters the active mode, it may receive the first input logic signal from external or other logic devices, and may output the first output logic signal as a response to the same. The second interface module 921 may output the first output logic signal through a fourth path 941. The first output logic signal may be provided to the first interface module 911 as a second input signal through the second plurality of metal layers 923, an interconnection structure 931b, the first plurality of metal layers 913, and the like. For example, the first output logic signal may be provided to the first interface module 911 as the second input logic signal through a metal layer among the second plurality of metal layers 923 within a routing path from the second interface module 921 to the interconnection structure 931b, the interconnection structure 931b, and a metal layer among the first plurality of metal layers 913 within a routing path from the interconnection structure 931b to the first interface module 911. The first interface module 911 may receive the second input logic signal through the fourth path 941 in the active mode.

However, although it is described here that the first interface module 911 receives the logic signal output by the second interface module 921, the scope of the present disclosure is not limited thereto. For example, the second interface module 921 may receive the logic signal output by the first interface module 911 based on the virtual power voltage VVDD. At this time, the path along which the logic signal moves may be similar to the path of the logic signal described above.

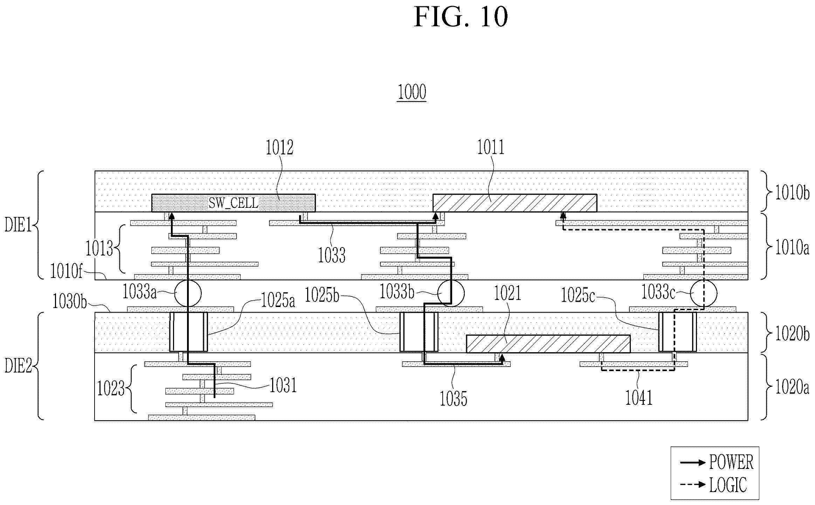

FIG. 10 is a schematic cross-sectional view of an example of a three-dimensional integrated circuit according to some implementations. Specifically, in the three-dimensional integrated circuit 1000 a front surface 1010f of the first semiconductor die DIE1 and a rear surface 1030b of the second semiconductor die DIE2 are disposed in contact with each other, whererin the first semiconductor die DIE1 includes the switch cell SW_CELL. The first semiconductor die DIE1 may be a top die, and the second semiconductor die DIE2 may be a bottom die. Here, although only a portion of the three-dimensional integrated circuit 1000 is illustrated, each die may include more configurations. In addition, the three-dimensional integrated circuit 1000 may include additional dies above and/or below the first semiconductor die DIE1 and the second semiconductor die DIE2. For brevity, descriptions redundant to FIG. 8 and FIG. 9 may not be included herein.

The first plurality of metal layers 1013 of the first semiconductor die DIE1 and a second plurality of metal layers 1023 of the second semiconductor die DIE2 may be connected to interconnection structures 1033a, 1033b, and 1033c. The first semiconductor die DIE1 and the second semiconductor die DIE2 may transmit and receive the power voltage and the logic signals through the interconnection structures 1033a, 1033b, and 1033c, redistribution structures, through-silicon vias 1025a, 1025b, and 1025c, and the like.

In some implementations, a first substrate layer 1010b of the first semiconductor die DIE1 may include a switch cell 1012 and a first interface module 1011. A second substrate layer 1020b of the second semiconductor die DIE2 may include a second interface module 1021.

In some implementations, the switch cell 1012 may receive the power voltage RVDD from an exterior of the first semiconductor die DIE1 through the second semiconductor die DIE2. For example, the switch cell 1012 may receive the power voltage RVDD from the exterior through the second plurality of metal layers 1023 within the second BEOL layer 1020a, the through-silicon via 1025a, the interconnection structure 1033a, and the first plurality of metal layers 1013 and the like within the first BEOL layer 1010a. For example, the switch cell 1012 may receive the power voltage RVDD from the exterior through a metal layer among the second plurality of metal layers 1023 within a routing path from the outside to the through-silicon via 1025a, the through-silicon via 1025a, the interconnection structure 1033a, and a metal layer among the first plurality of metal layers 1013 within a routing path from the interconnection structure 1033a to the switch cell 1012. The switch cell 1012 may receive the power voltage RVDD from the outside through a first path 1031.

In some implementations, the switch cell 1012 may output the virtual power voltage VVDD based on the control signal. The switch cell 1012 may provide the virtual power voltage VVDD to the first interface module 1011 through a second path 1033, and may provide the virtual power voltage VVDD to the second interface module 1021 through a third path 1035. The switch cell 1012 may provide the virtual power voltage VVDD to the first interface module 1011 through the first plurality of metal layers 1013. For example, the switch cell 1012 may provide the virtual power voltage VVDD to the first interface module 1011 through a metal layer among the first plurality of metal layers 1013 within a routing path from the switch cell 1012 to the first interface module 1011. The switch cell 1012 may provide the virtual power voltage VVDD to the second interface module 1021 through the first plurality of metal layers 1013, an interconnection structure 1033b, a through-silicon via 1025b, and the like. For example, the switch cell 1012 may provide the virtual power voltage VVDD to the second interface module 1021 through a metal layer among the first plurality of metal layers 1013 within a routing path from the switch cell 1012 to the interconnection structure 1033b, the interconnection structure 1033b, the through-silicon via 1025b, and a metal layer among the second plurality of metal layers 1023 within a routing path from the through-silicon via 1025b to the second interface module 1021.

In some implementations, the first interface module 1011 and the second interface module 1021 may operate in the active mode based on the virtual power voltage VVDD. The first interface module 1011 and the second interface module 1021 may operate together in the active mode based on the virtual power voltage VVDD. When the second interface module 1021 enters the active mode, the second interface module 1021 may receive the first input logic signal from external or other logic devices, and may output the first output logic signal as a response to the same. The second interface module 1021 may output the first output logic signal through a fourth path 1041. The first output logic signal may be provided to the first interface module 1011 as a second input signal through the second plurality of metal layers 1023, a through-silicon via 1025c, an interconnection structure 1033c, the first plurality of metal layers 1013, and the like. For example, the first output logic signal may be provided to the first interface module 1011 as a second input signal through a metal layer among the second plurality of metal layers 1023 within a routing path from the second interface module 1021 to the through-silicon via 1025c, the interconnection structure 1033c, and a metal layer among the first plurality of metal layers 1013 within a routing path from the interconnection structure 1033c to the first interface module 1011. The first interface module 1011 may receive the second input logic signal through the fourth path 1041 in the active mode.

However, although it is described here that the first interface module 1011 receives the logic signal output by the second interface module 1021, the scope of the present disclosure is not limited thereto. For example, the second interface module 1021 may receive the logic signal output by the first interface module 1011 based on the virtual power voltage VVDD. At this time, the path along which the logic signal moves may be similar to the path of the logic signal described above.

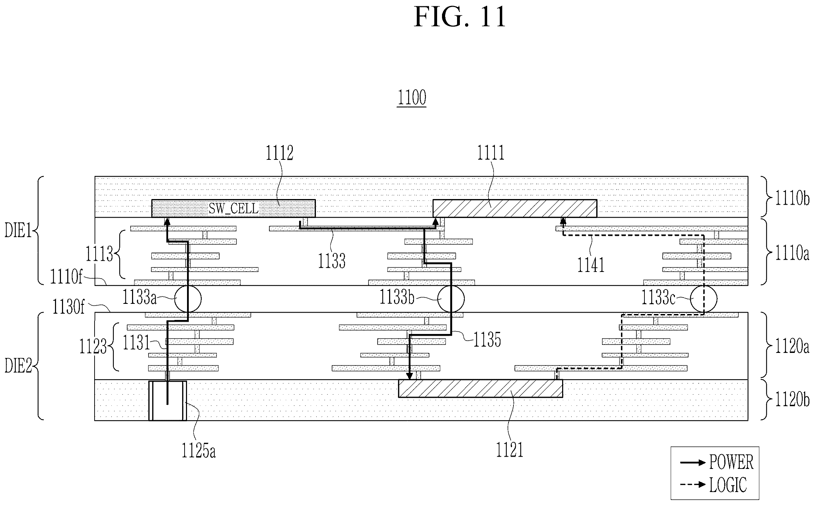

FIG. 11 is a schematic cross-sectional view of an example of a three-dimensional integrated circuit according to some implementations. Specifically, in the three-dimensional integrated circuit 1100 a front surface 1110f of the first semiconductor die DIE1 and a front surface 1130f of the second semiconductor die DIE2 are disposed in contact with each other, wherein the first semiconductor die DIE1 includes the switch cell SW_CELL. The first semiconductor die DIE1 may be a top die, and the second semiconductor die DIE2 may be a bottom die. Here, although only a portion of a three-dimensional integrated circuit 1100 is illustrated, each die may include more configurations. In addition, the three-dimensional integrated circuit 1100 may include additional dies above and/or below the first semiconductor die DIE1 and the second semiconductor die DIE2. In addition, descriptions redundant to FIG. 8 to FIG. 10 is not included herein.

The first plurality of metal layers 1113 of the first semiconductor die DIE1 and a second plurality of metal layers 1123 of the second semiconductor die DIE2 may be connected to interconnection structures 1133a, 1133b, and 1133c. The first semiconductor die DIE1 and the second semiconductor die DIE2 may transmit and receive power voltage and the logic signals through the interconnection structures 1133a, 1133b, and 1133c.

In some implementations, a first substrate layer 11 10b of the first semiconductor die DIE1 may include a switch cell 1112 and a first interface module 1111. A second substrate layer 1120b of the second semiconductor die DIE2 may include a second interface module 1121.

In some implementations, the switch cell 1112 may receive the power voltage RVDD from an exterior of the first semiconductor die DIE1 through the second semiconductor die DIE2. For example, the switch cell 1112 may receive the power voltage RVDD from the exterior through the second plurality of metal layers 1123 within the second BEOL layer 1120a, the interconnection structure 1133a, the first plurality of metal layers 1113 within the first BEOL layer 1110a, and the like. For example, the switch cell 1112 may receive the power voltage RVDD from the exterior through a through-silicon via 1125a, a metal layer among the second plurality of metal layers 1123 within a routing path from the through-silicon via 1125a to the interconnection structure 1133a, the interconnection structure 1133a, and a metal layer among the first plurality of metal layers 1113 within a routing path from the interconnection structure 1133a to the switch cell 1112. The switch cell 1112 may receive the power voltage RVDD from the exterior through a first path 1131.

In some implementations, the switch cell 1112 may output the virtual power voltage VVDD based on the control signal. The switch cell 1112 may provide the virtual power voltage VVDD to the first interface module 1111 through a second path 1133, and may provide the virtual power voltage VVDD to the second interface module 1121 through a third path 1135. The switch cell 1112 may provide the virtual power voltage VVDD to the first interface module 1111 through the first plurality of metal layers 1113. For example, the switch cell 1112 may provide the virtual power voltage VVDD to the first interface module 1111 through a metal layer among the first plurality of metal layers 1113 within a routing path from the switch cell 1112 to the first interface module 1111. The switch cell 1112 may provide the virtual power voltage VVDD to the second interface module 1121 through the first plurality of metal layers 1113, an interconnection structure 1 133b, the second plurality of metal layers 1123, and the like. For example, the switch cell 1112 may provide the virtual power voltage VVDD to the second interface module 1121 through a metal layer among the first plurality of metal layers 1113 within a routing path from the switch cell 1112 to the interconnection structure 1133b, the interconnection structure 1133b, and a metal layer among the second plurality of metal layers 1123 within a routing path from the interconnection structure 1133b to the second interface module 1121.

In some implementations, the first interface module 1111 and the second interface module 1121 may operate in the active mode based on the virtual power voltage VVDD. The first interface module 1111 and the second interface module 1121 may operate together in the active mode based on the virtual power voltage VVDD. When the second interface module 1121 enters the active mode, the second interface module 1121 may receive the first input logic signal from external or other logic devices, and may output the first output logic signal as a response to the same. The second interface module 1121 may output the first output logic signal through a fourth path 1141. The first output logic signal may be provided to the first interface module 1111 as a second input signal through the second plurality of metal layers 1123, an interconnection structure 1 133c, the first plurality of metal layers 1113, and the like. For example, the first output logic signal may be provided to the first interface module 1111 as a second input signal through a metal layer among the second plurality of metal layers 1123 within a routing path from the second interface module 1121 to the interconnection structure 1 133c, the interconnection structure 1 133c, and a metal layer among the first plurality of metal layers 1013 within a routing path from the interconnection structure 1133c to the first interface module 1111. The first interface module 1111 may receive the second input logic signal through the fourth path 1141 in the active mode.

However, although it is described here that the first interface module 1111 receives the logic signal output by the second interface module 1121, the scope of the present disclosure is not limited thereto. For example, the second interface module 1121 may receive the logic signal output by the first interface module 1111 based on the virtual power voltage VVDD. At this time, the path along which the logic signal moves may be similar to the path of the logic signal described above.

In some implementations, the first semiconductor die DIE1 and the second semiconductor die DIE2 have the same size was described, as an example. However, when the area of the first semiconductor die DIE1 including the switch cell is greater than the area of the second semiconductor die DIE2, the first semiconductor die DIE1 may directly receive the power voltage RVDD from the outside without passing through the second semiconductor die DIE2. For example, the first semiconductor die DIE1 may directly receive the power voltage RVDD from the outside through a copper post (Cu post) or the like, but is not limited thereto.

In addition, a three-dimensional integrated circuit may include the plurality of semiconductor dies in which a rear surface of the first semiconductor die DIE1 and a rear surface of the second semiconductor die DIE2 are disposed in contact with each other. In some implementations, at least one semiconductor die among the plurality of semiconductor dies may include the switch cell, and the transmitting and receiving method of the power voltage and the logic signals between the plurality of semiconductor dies may be the same as or similar to the method described with reference to FIG. 8 to FIG. 11.

In FIG. 8 to FIG. 11, the semiconductor dies in the three-dimensional integrated circuit may be disposed in contact with each other in various structures, and may transmit and receive the power voltage and the logic signals through different structures according to the structure disposed in contact with each other. In a three-dimensional integrated circuit, in consideration of the area of semiconductor dies, the number, routing wires, and the like of logic devices within semiconductor dies, the switch cell is disposed only in some dies among the plurality of semiconductor dies, thereby efficiently utilizing the area of the plurality of semiconductor dies.

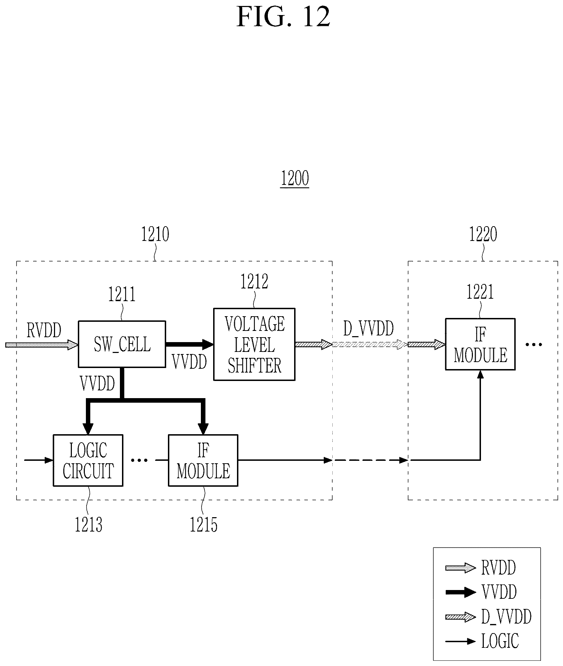

FIG. 12 is a drawing for schematically showing an example of an operation method of a three-dimensional integrated circuit according to some implementations. Specifically, levels of power voltages for operating logic devices within the semiconductor dies included in the three-dimensional integrated circuit are different.

In some implementations, a three-dimensional integrated circuit 1200 may include a first semiconductor die 1210 and a second semiconductor die 1220. The first semiconductor die 1210 may include a switch cell 1211. The switch cell 1211 may receive the power voltage RVDD from an exterior of the first semiconductor die 1210, and may provide the virtual power voltage VVDD to a logic circuit 1213 and a first interface module 1215, and may also provide the virtual power voltage VVDD to a second interface module 1221 within the second semiconductor die 1220. The logic circuit 1213, the first interface module 1215, and the second interface module 1221 may simultaneously operate in the active mode based on the virtual power voltage VVDD. The logic circuit 1213, the first interface module 1215, and the second interface module 1221 may receive or output a logic signal in the active mode.

In some implementations, the level of the virtual power voltage for the second interface module 1221 to operate in the active mode may be different from the level of the virtual power voltage for the first interface module 1215 to operate in the active mode. Accordingly, the second interface module 1221 needs to be supplied with the virtual power voltage of a different level from that of the virtual power voltage VVDD.

In some implementations, the first semiconductor die 1210 may include a voltage level shifter 1212. The voltage level shifter 1212 may receive the virtual power voltage VVDD, and may output the virtual power voltage D_VVDD with an inverted or shifted level. The first semiconductor die 1210 may provide the virtual power voltage D_VVDD with a converted level to the second semiconductor die 1220. The first semiconductor die 1210 may provide the virtual power voltage D_VVDD with a converted level to the second interface module 1221 of the second semiconductor die 1220 through a substrate-through via, a micro-bump, a solder bump, a hybrid copper bonding, or the like. The second interface module 1221 may enter the active mode based on the virtual power voltage D_VVDD with a converted level, and may receive the logic signal from the first semiconductor die 1210 in the active mode.

The structure of the first semiconductor die 1210 and the second semiconductor die 1220 and the method by which the first semiconductor die 1210 and the second semiconductor die 1220 transmit and receive the power voltage and the logic signal may be the same as or similar to the structure and method described with reference to FIG. 8 to FIG. 11.

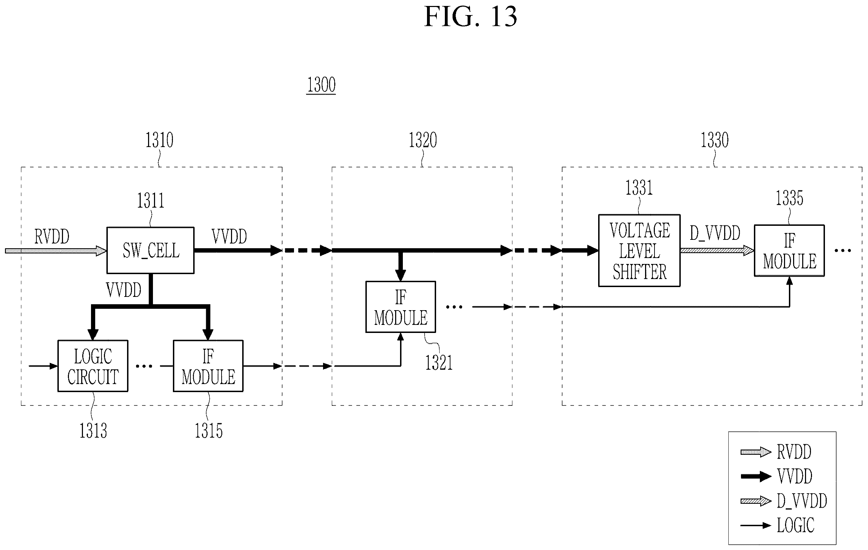

FIG. 13 is a drawing for schematically showing an example of an operation method of a three-dimensional integrated circuit according to some implementations. Specifically, a level of power voltage for operating the logic devices within semiconductor dies included in the three-dimensional integrated circuit are different, which is a three-dimensional integrated circuit including three or more semiconductor dies.

In some implementations, a three-dimensional integrated circuit 1300 may include a first semiconductor die 1310, a second semiconductor die 1320, and a third semiconductor die 1330. The first semiconductor die 1310 may include a switch cell 1311. The switch cell 1311 may receive the power voltage RVDD from an exterior of the first semiconductor die 1310, and may provide the virtual power voltage VVDD to a logic circuit 1313 and a first interface module (circuit) 1315, and may also provide the virtual power voltage VVDD to a second interface module (circuit) 1321 within the second semiconductor die 1320 and to the third semiconductor die 1330. The logic circuit 1313, the first interface module 1315, and the second interface module 1321 may simultaneously operate in the active mode based on the virtual power voltage VVDD. The logic circuit 1313, the first interface module 1315, and the second interface module 1321 may receive or output a logic signal in the active mode.

In some implementations, the third semiconductor die 1330 may include a voltage level shifter 1331 and a third interface module (circuit) 1335. The level of power voltage for the third interface module 1335 to operate in the active mode may be different from the level of power voltage for the first interface module 1315 and the second interface module 1321 to operate in the active mode. Accordingly, the third interface module 1335 needs to be supplied with the virtual power voltage of a different level from that of the virtual power voltage VVDD. The third semiconductor die 1330 may include the voltage level shifter 1331 in order to provide the virtual power voltage D_VVDD with a converted level to the third interface module 1335. The voltage level shifter 1331 may receive the virtual power voltage VVDD from the second semiconductor die 1320, and may output the virtual power voltage D_VVDD with an inverted or shifted level. The third interface module 1335 may operate in the active mode simultaneously with the logic circuit 1313, the first interface module 1315, and the second interface module 1321 based on the virtual power voltage D_VVDD with a converted level. The third interface module 1335 may enter the active mode based on the virtual power voltage D_VVDD with a converted level, and may receive the logic signal from the second semiconductor die 1320 in the active mode.

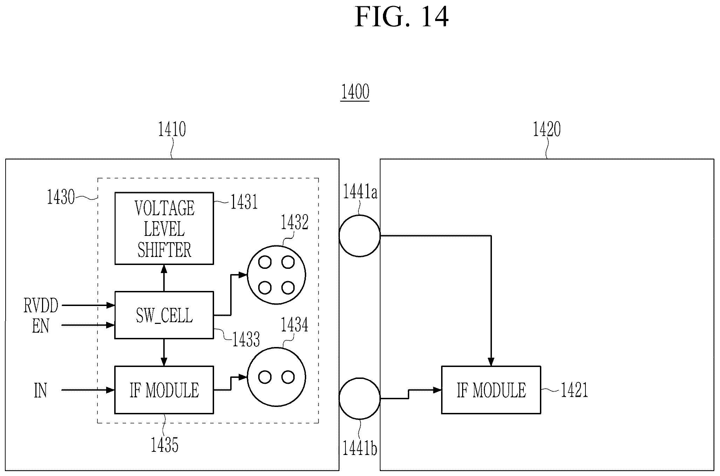

FIG. 14 is a drawing for showing an example of a three-dimensional integrated circuit according to some implementations. Specifically, some semiconductor dies of the three-dimensional integrated circuit include the switch cell, and structures required to transmit and receive the power voltage and the logic signal are modularized.

In some implementations, a three-dimensional integrated circuit 1400 may include a first semiconductor die 1410 and a second semiconductor die 1420, and only the first semiconductor die 1410 may include a switch cell 1433. In order to provide the virtual power voltage VVDD generated by the switch cell 1433, it may be provided to a second interface module (circuit) 1421 of the second semiconductor die 1420 through a first through-silicon via 1432. When power voltage levels for operating the logic devices of the first semiconductor die 1410 and the logic devices of the second semiconductor die 1420 are different, a voltage level shifter 1431 may be necessary. The first semiconductor die 1410 and the second semiconductor die 1420 may transmit and receive the virtual power voltage VVDD through a first interconnection structure 1441a.

In some implementations, a first interface module (circuit) 1435 of the first semiconductor die 1410 may output the logic signal based on the virtual power voltage VVDD. The logic signal may be provided in the second interface module 1421 through a second through-silicon via 1434. The first semiconductor die 1410 and the second semiconductor die 1420 may transmit and receive the logic signal through a second interconnection structure 1441b.

In some implementations, the structures required for the first semiconductor die 1410 to transfer the virtual power voltage VVDD and the logic signals to the second semiconductor die 1420 may be implemented as one macro circuit 1430. For example, the macro circuit 1430 may include the voltage level shifter 1431, the switch cell 1433, the first interface module 1435, the first through-silicon via 1432 for transmitting and receiving the virtual power voltage VVDD, and the second through-silicon via 1434 for transmitting and receiving the logic signal. The first semiconductor die 1410 may include a plurality of macro circuits 1430, and by disposing the plurality of macro circuits 1430 to be spaced apart at appropriate intervals, the virtual power voltage VVDD and the logic signals may be efficiently transferred to the second semiconductor die 1420. However, the configuration of the macro circuit 1430 is not limited thereto, and some configurations may be omitted, and other configurations may be added.

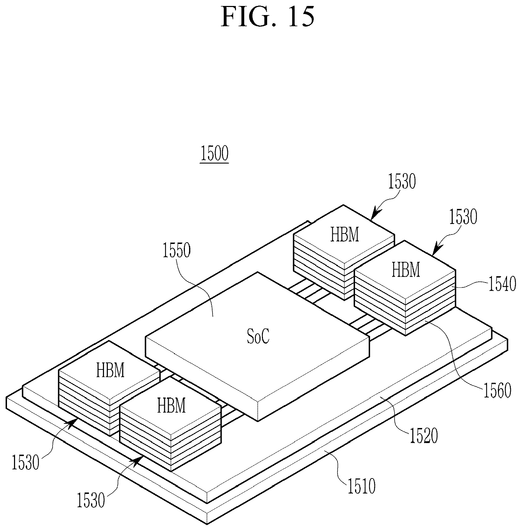

FIG. 15 is a drawing showing an example of a semiconductor device according to some implementations. In FIG. 15, a semiconductor device 1500 may be a memory module (circuit) including a system-on-chip (SOC) 1550 and at least one stack semiconductor chip 1530 mounted on a package substrate 1510, such as a printed circuit board.

In some implementations, an interposer 1520 may be further provided on the package substrate 1510. The stack semiconductor chip 1530 may be formed as chip-on-chip (CoC). The stack semiconductor chip 1530 may include at least one memory chip 1540 stacked on a buffer chip 1560 such as a logic chip. The buffer chip 1560 and the at least one memory chip 1540 may be interconnected by a through-silicon via (TSV). In some implementations, the buffer chip 1560 and the at least one memory chip 1540 may include the switch cell and interface modules described with reference to FIG. 1 to FIG. 14. Accordingly, the semiconductor device 1500 may be designed such that only the at least one memory chip 1540 as a part of the stack semiconductor chip 1530 may include the switch cell, and thereby the area of the semiconductor device 1500 may be efficiently utilized. In some implementations, the stack semiconductor chip 1530 may be, for example, a high-bandwidth memory HBM of 500GB/sec to 1TB/sec, or more.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. An integrated circuit, comprising:
a switch cell (210, 311, 510, 822, 922, 1012, 1112, 1211, 1311, 1433) on a first substrate (820b; 920b; 1010b; 1110b) within a first die (310; 710; DIE2; DIE1; 1210; 1310; 1410) among a plurality of stacked dies (310, 320; 710, 720; DIE1, DIE2; 1210, 1220; 1310, 1320, 1330; 1410, 1420), the switch cell being configured to output a virtual power voltage (VVDD) based on a power voltage (RVDD) received from an exterior of the first die;
a first interface circuit (315; 821; 921, 1011; 1111; 1215; 1315; 1435) on the first substrate (820b; 920b; 1010b; 1110b), the first interface circuit configured to enter an active mode based on the virtual power voltage (VVDD); and
a second interface circuit (321; 811; 911; 1021; 1121;1221; 1321; 1421) on a second substrate (810b; 910b; 1020b; 1120b) within a second die (320; 720; DIE1; DIE2; 1220; 1320; 1420) bonded to the first die (310; 710; DIE2; DIE1; 1210; 1310; 1410) among the plurality of dies, the second interface circuit configured to enter the active mode together with the first interface circuit based on the virtual power voltage (VVDD).

2. The integrated circuit of claim 1,
wherein the switch cell (210, 311, 510, 822, 922, 1012, 1112, 1211, 1311, 1433) is configured to provide the virtual power voltage (VVDD) to the first interface circuit (315; 821; 921, 1011; 1111; 1215; 1315; 1435) through a first path (833; 933; 1033; 1133), and
wherein the switch cell (210, 311, 510, 822, 922, 1012, 1112, 1211, 1311, 1433) is configured to provide the virtual power voltage (VVDD) to the second interface circuit through a second path (835; 935; 1035; 1135) different from the first path (833; 933; 1033; 1133).

3. The integrated circuit of claim 2, wherein a rear surface (830b) of the first die (DIE2) is bonded to a front surface (810f) of the second die (DIE1).

4. The integrated circuit of claim 3,
wherein, in the active mode, the first interface circuit (821) and the second interface circuit (811) are configured to transmit and receive a logic signal through a third path (843) different from the first path (833) and the second path (835),
wherein the first die comprises a first through-silicon via, TSV, (825a) and a second through-silicon via (825b) penetrating the first substrate (820b),
wherein the second path (835) comprises the first through-silicon via (825a), and
wherein the third path (843) comprises the second through-silicon via (825b).

5. The integrated circuit of claim 2, wherein a front surface (930f; 1110f) of the first die (DIE2; DIE1) is bonded to a front surface (910f; 1130f) of the second die (DIE1; DIE2).

6. The integrated circuit of claim 5,
wherein the first interface circuit (921; 1111) and the second interface circuit (911; 1121) are configured to transmit and receive a logic signal through a third path (941; 1141) different from the first path (933; 1133) and the second path (935; 1135) in the active mode,
wherein the integrated circuit further comprises a first interconnection structure (931a; 1133b) and a second interconnection structure (931b; 1133a) attached between the front surface (930f) of the first die (DIE2; DIE1) and the front surface (910f) of the second die (DIE1; DIE2),
wherein the second path (935; 1135) comprises the first interconnection structure (931a; 1133b), and
wherein the third path (941; 1141) comprises the second interconnection structure (931b; 1133c).

7. The integrated circuit of claim 6,
wherein the second substrate (1120b) comprises a first through-silicon via (1125a), and
wherein the switch cell (1112) is configured to receive the power voltage (RVDD) through the first through-silicon via (1125a).

8. The integrated circuit of claim 2, wherein a front surface (1010t) of the first die (DIE1) is bonded to a rear surface (1030b) of the second die (DIE2).

9. The integrated circuit of claim 8,
wherein the first interface circuit (1011) and the second interface circuit (1021) are configured to transmit and receive a logic signal through a third path (1041) different from the first path (1033) and the second path (1035) in the active mode,
wherein the second die (DIE2) comprises a first through-silicon via (1025a), a second through-silicon via (1025b), and third through-silicon via (1025c) extending into the second substrate (1020b),
wherein the switch cell (1012) is configured to receive the power voltage (RVDD) through the first through-silicon via (1025a),
wherein the second path (1035) comprises the second through-silicon via (1025b), and wherein the third path (1041) comprises the third through-silicon via (1025c).

10. The integrated circuit according to any one of the preceding claims,
wherein the first die (310; 710; DIE2; DIE1; 1210; 1310; 1410) comprises a first plurality of metal lines (ML; 711) extending in a first direction (X),
wherein the switch cell (SW_CELL) is disposed to overlap the first plurality of metal lines (ML; 711) and configured to provide the virtual power voltage (VVDD) to the first plurality of metal lines (ML; 711) based on the power voltage (RVDD) received from the exterior of the first die (310; 710; DIE2; DIE1; 1210; 1310; 1410),
wherein the second die comprises a second plurality of metal lines (731) extending in the first direction (X) and configured to receive the virtual power voltage (VVDD) from the first die (310; 710; DIE2; DIE1; 1210; 1310; 1410), and
wherein the second interface circuit (321; 811; 911; 1021; 1121;1221; 1321; 1421) is disposed to overlap the second plurality of metal lines (731) and to enter the active mode together with the first interface circuit (315; 821; 921, 1011; 1111; 1215; 1315; 1435) based on the virtual power voltage (VVDD) received from the second plurality of metal lines (731).

11. The integrated circuit of claim 10,
wherein the first die (1210) further comprise a voltage level shifter (1212) configured to output the virtual power voltage (D_VVDD) of a second level different from a first level, based on the virtual power voltage (VVDD) of the first level received from the switch cell, and
wherein the second plurality of metal lines (731) are configured to receive the virtual power voltage (D_VVDD) of the second level from the first die (1210).

12. The integrated circuit of claim 10 or 11, further comprising a first through-silicon via (1025b) configured to transfer the virtual power voltage (VVDD) from the first die (DIE1) to the second die (DIE2).

13. The integrated circuit of any one of claims 10 to 12, further comprising a third die (1330) comprising a third plurality of metal lines extending in the first direction and configured to receive the virtual power voltage (VVDD) from the first die (1310) and a third interface circuit (1335) disposed to overlap the third plurality of metal lines and to enter the active mode together with the first interface circuit (1325) and the second interface circuit (1321) based on the virtual power voltage (VVDD) received from the third plurality of metal lines.

14. The semiconductor device of any one of claims 10 to 13, wherein the first die comprises a plurality of the switch cells.

15. The semiconductor device of claim 1, wherein:
the switch cell (1211) is configured to output the virtual power voltage (VVDD) of a first level based on the power voltage (RVDD) received from the exterior of the first die (1210),
the first interface circuit (1215) is configured to output a logic signal based on the virtual power voltage (VVDD) of the first level received from the switch cell (1211),
the first die (1210) comprises a level shifter (1212) configured to output the virtual power voltage (D_VVDD) of a second level different from the first level based on the virtual power voltage (VVDD) of the first level received from the switch cell (1211), a first through-silicon via configured to transfer the virtual power voltage (VVDD) of the second level to the exterior of the first die (1210), and a second through-silicon via configured to transfer the logic signal to the exterior of the first die (1210); and
the second interface circuit (1221) is configured to receive the logic signal through the second through-silicon via based on the virtual power voltage (D_VVDD) of the second level received from the first through-silicon via.
